# EUROPEAN PATENT APPLICATION

(11) **EP 4 439 881 A1**
(43) Date of publication of application: **02.10.2024**
(21) Application number: 22897491.1
(22) Date of filing: 24.10.2022
(51) Int. Cl.: H01S 5/024, H01S 5/02335, H01S 5/02253

(54) **LASER PACKAGING DEVICE**

(30) Priority: 24.11.2021 CN 202122898249 U
(71) Applicant: Shenzhen Lighting Institute, Shenzhen, Guangdong 518110 (CN)
(72) Inventor: TANG, Huai, Shenzhen, Guangdong 518110 (CN); GUO, Yanyu, Shenzhen, Guangdong 518110 (CN)
(74) Representative: Noréns Patentbyrå AB
(86) International application number: PCT/CN2022/126905
(87) International publication number: WO 2023/093408

(57) **Abstract**

A laser packaging device (1), comprising a base (10), a laser light source assembly (30), a lead wire (50), and a light window (60). The base (10) comprises a light source mounting portion (11) and a support portion (13); the light source mounting portion (11) and the support portion (13) are integrally arranged, and the light source mounting portion cooperates with the support portion (13) to form an accommodating cavity (15); the support portion (13) comprises a top surface (132) and a bottom surface (134); the laser light source assembly (30) is accommodated in the accommodating cavity (15) and is provided at the light source mounting portion (11); the laser light source assembly (30) is configured to emit laser; the lead wire (50) passes through the support portion (13); the lead wire (50) comprises a first end (52) and a second end (54) opposite to each other; the first end (52) is provided in the accommodating cavity (15) and is configured to be electrically connected with the laser light source assembly (30); the second end (54) is provided on the bottom surface (134); the light window (60) covers the top surface (132) to seal the accommodating cavity (15); and the laser is emitted through the light window (60). The light source mounting portion (11) and the support portion (13) are integrally arranged, thereby simplifying the manufacturing process of the base (10). In addition, the first end (52) of the lead wire (50) is provided in the accommodating cavity (15), and the second end (54) is provided on the bottom surface (134) of the support portion (13), thereby facilitating a decrease in the size of the base (10) and achievement of miniaturization of the laser packing device (1).

## Description

### TECHNICAL FIELD

The present disclosure relates to the technical field of laser packaging and, in particular, to a laser packaging device.

### BACKGROUND

With the development of laser chip packaging technology, laser chip has been more and more widely used in the fields of laser lighting and display. The manufacturing process of laser chip packaging on the market is complex and usually has a large size, which limit the further development of laser chip packaging technology.

### SUMMARY

The purpose of the embodiments of the present disclosure is to provide a laser packaging device to solve the above problems. The embodiments of the present disclosure achieve the above purpose through the following technical solutions.

The present disclosure provides a laser packaging device, including a base, a laser light source assembly, a lead wire and a light window. The base includes a light source mounting portion and a support portion. The light source mounting portion and the support portion are integrally provided and cooperate to form an accommodating cavity. The support portion includes a top surface and a bottom surface. The laser light source assembly is accommodated in the accommodating cavity and provided at the light source mounting portion. The laser light source assembly is configured to emit a laser. The lead wire passes through the support portion and includes a first end and a second end opposite to each other. The first end of the lead wire is provided in the accommodating cavity and configured to be electrically connected with the laser light source assembly, and the second end of the lead wire is provided on the bottom surface. The light window covers the top surface to seal the accommodating cavity, and the laser is emitted through the light window.

In an embodiment, the support portion further includes a side surface connected to the top surface and the bottom surface, and the side surface is flush with a part of an outer surface of the light window.

In an embodiment, the light source mounting portion includes an inner surface located between the top surface and the bottom surface, and the laser light source assembly is provided on the inner surface. The support portion further includes a step surface located between the top surface and the inner surface. The first end of the lead wire is provided on the step surface.

In an embodiment, the laser light source assembly includes a laser chip and a reflector. The laser chip is electrically connected to the first end of the lead wire. The laser chip includes two light emission sources. Each of the emission sources is configured to emit the laser. The laser is reflected to the light window through the reflector.

In an embodiment, the laser packaging device includes a plurality of laser light source assemblies. The plurality of laser light source assemblies are provided at intervals.

In an embodiment, the base has a length direction and a width direction. The plurality of laser light source assemblies are provided at intervals along the length direction of the base. The laser chip and the reflector of each of the laser light source assemblies are provided along the width direction of the base. One laser chip is provided between every two adjacent reflectors along the length direction of the base.

In an embodiment, a laser chip of each of the laser light source assemblies is staggered from a reflector of an adjacent laser light source assembly along the width direction of the base to increase the spacing, in the width direction of the base, between two adjacent laser chips.

In an embodiment, the base is made of ceramic material.

In an embodiment, the laser packaging device further includes a collimating lens, and the collimating lens is provided at a side of the light window away from the base.

In an embodiment, the collimating lens includes a lens body and a plurality of collimating units. The lens body is connected to the light window, and the plurality of collimating units are provided at the lens body. The laser packaging device includes a plurality of laser light source assemblies. Each of the laser light source assemblies corresponds to one collimating unit.

Compared with the prior art, with respect to the laser packaging device according to the embodiments of the present disclosure, the light source mounting portion and the support portion are integrally provided, such that the manufacturing process of the base is simplified. In addition, the first end of the lead wire is provided in the accommodating cavity, and the second end of the lead wire is provided on the bottom surface of the support portion, thereby facilitating reducing the size of the base and achieving miniaturization of the laser packaging device.

These or other aspects of the present disclosure will be more concise and easy to understand in the description of the following embodiments.

### BRIEF DESCRIPTION OF DRAWINGS

In order to better describe the technical solutions in the embodiments of the present disclosure, the drawings which are needed in the description of the embodiments will be briefly introduced as follows. It is appreciated that the drawings in the following description are only some of the embodiments of the present disclosure, and for those of ordinarily skilled in the art, other drawings can also be obtained in accordance with these drawings without any creative effort.
FIG. 1 is a structural schematic diagram of a laser packaging device according to the present disclosure;
FIG. 2 is a longitudinal cross-sectional view of the laser packaging device shown in FIG. 1;
FIG. 3 is an optical path diagram of the laser packaging device shown in FIG. 1 along a length direction of a base;
FIG. 4 is an optical path diagram of the laser packaging device shown in FIG. 1 along a width direction of the base;
FIG. 5 is a diagram showing an arrangement of a plurality of laser light source assemblies of the laser packaging device shown in FIG. 1;
FIG. 6 is a top view of the diagram showing the arrangement of the plurality of laser light source assemblies of the laser packaging device shown in FIG. 5;
FIG. 7 is a diagram showing another arrangement of a plurality of laser light source assemblies of the laser packaging device shown in FIG. 1; and
FIG. 8 is a top view of the diagram showing the arrangement of the plurality of laser light source assemblies of the laser packaging device shown in FIG. 7.

### DESCRIPTION OF EMBODIMENTS

In order to facilitate understanding the embodiments of the present disclosure, the embodiments of the present disclosure will be described in detail in conjunction with the drawings hereinafter. The preferred implementations of the present disclosure are provided by the drawings. However, the present disclosure can be implemented in many different forms, but not limited to the implementations herein. On the contrary, the purpose of providing the embodiments is just to make the contents of the present disclosure understood more thoroughly and comprehensively.

Unless otherwise defined, all technical and scientific terms used herein have the same meanings as those commonly understood by those skilled in the art of the present disclosure. The terms used in the embodiments of the present disclosure are just for the purpose of describing specific implementations, but not intended to limit the present disclosure.

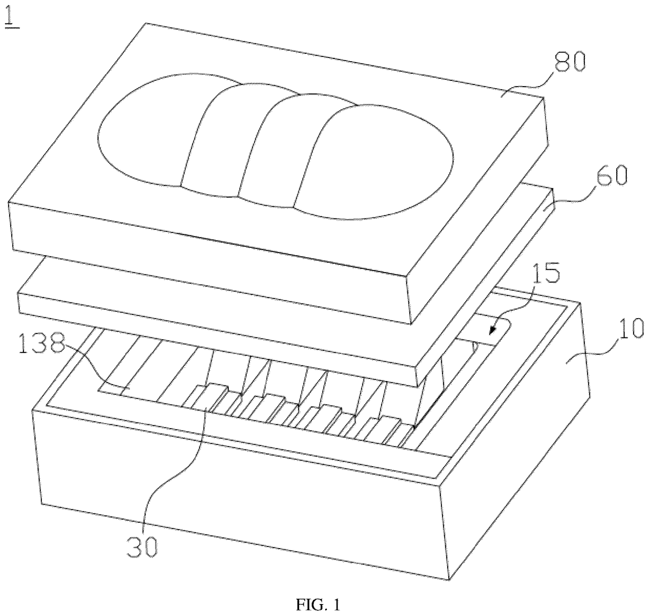

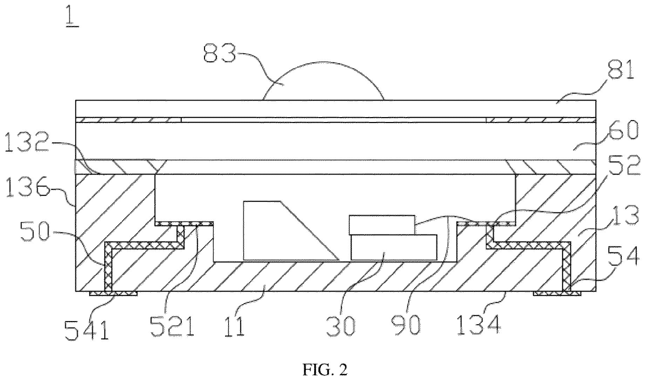

As shown in FIG. 1 and FIG. 2, the present disclosure provides a laser packaging device 1, including a base 10, a laser light source assembly 30, a lead wire 50 and a light window 60. The base 10 includes a light source mounting portion 11 and a support portion 13. The light source mounting portion 11 and the support portion 13 are integrated provided and cooperate with each other to form an accommodating cavity 15. The support portion 13 includes a top surface 132 and a bottom surface 134. The laser light source assembly 30 is accommodated in the accommodating cavity 15 and provided at the light source mounting portion 11. The laser light source assembly 30 is configured to emit a laser. The lead wire 50 passes through the support portion 13 and includes a first end 52 and a second end 54 opposite to each other. The first end 52 of the lead wire 50 is provided in the accommodating cavity 15 and configured to be electrically connected to the laser light source assembly 30, and the second end 54 of the lead wire 50 is provided on the bottom surface 134. The light window 60 covers the top surface 132 of the support portion 13 to seal the accommodating cavity 15, and the laser is emitted through the light window 60.

In an embodiment, the base 10 is substantially an open rectangular shell, and the base 10 has a length direction and a width direction. In addition, the base 10 further has a height direction. The length direction, the width direction, and the height direction are perpendicular to each other. In some other embodiments, the base 10 may also have other shapes such as an open cylindrical shell. The base 10 may be configured to mount structures such as the laser light source assembly 30 and light window 60. In this embodiment, the base 10 is made of ceramic materials, such as aluminum oxide or aluminum nitride ceramics, which have low cost and thereby can reduce the cost of the laser packaging device 1. In some other embodiments, the base 10 may also be made of copper material, such as oxygen-free copper or tungsten copper, to enhance the thermal conductivity of the base.

The base 10 includes the light source mounting portion 11 and the support portion 13. The light source mounting portion 11 may be configured to mount the laser light source assembly 30, and the support portion 13 may be configured to support the light window 60. In this embodiment, the light source mounting portion 11 and the support portion 13 are integrated provided, such that the manufacturing process of the base 10 can be simplified, and thereby the manufacturing process of the laser packaging device 1 can be simplified. For example, the light source mounting portion 11 and the support portion 13 of the base 10 can be manufactured through integrated sintering process.

The light source mounting portion 11 is substantially a rectangular plate. The light source mounting portion 11 can fit with the support portion 13 to form the accommodating cavity 15. In an embodiment, the accommodating cavity 15 may be configured to accommodate the laser light source assembly 30.

The light source mounting portion 11 includes an inner surface 112 located between the top surface 132 and the bottom surface 134 of the support portion 13. The inner surface 112 may be configured to arrange the laser light source assembly 30. For example, the laser light source assembly 30 may be bonded to the inner surface 112 through thermal conductive adhesive. The light source mounting portion 11 further includes an outer surface 114 opposite to the inner surface 112. In this embodiment, the outer surface 114 of the light source mounting portion 11 is coplanar with the bottom surface 134 of the support portion 13 to increase the contact area between the base 10 and a support surface such as a table, so that the laser packaging device 1 can be stably placed on the table.

The support portion 13 is substantially a rectangular frame, and is provided around the light source mounting portion 11. The support portion 13 further includes a side surface 136. The side surface 136 is connected to the top surface 132 and the bottom surface 134, and is flush with the outer surface 114 of the light window 60. That is, the length of the support portion 13 may be equal to the length of the light window 60, and the width of the support portion 13 may be equal to the width of the light window 60, thereby improving the appearance structure consistency of the laser packaging device 1 and facilitating the miniaturization of the laser packaging device 1. The length and width of the support portion 13 are the length and width of the rectangular frame, respectively. The light window 60 is substantially a rectangular plate, and the length and width of the light window 60 are the length and width of the rectangular plate, respectively. The support portion 13 further includes a step surface 138 (FIG. 1). The step surface 138 is located below the top surface 132 and above the inner surface 112. The step surface 138 is configured to arrange the lead wire 50. In this embodiment, there are two the step surfaces 138, and the two step surfaces 138 are flush with each other, and are provided at both sides of the laser light source assembly.

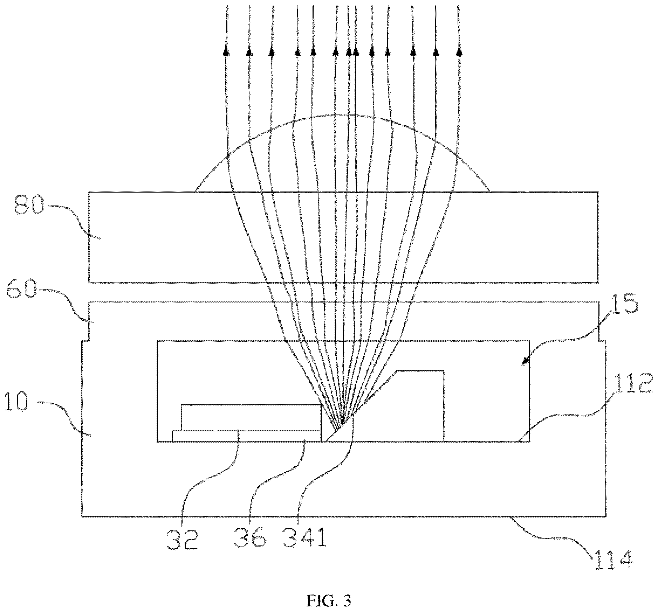

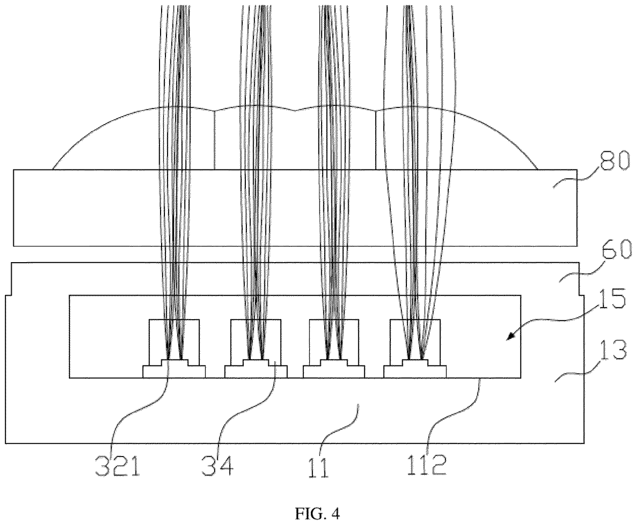

As shown in FIG. 3 and FIG. 4, the laser light source assembly 30 is accommodated in the accommodating cavity 15 and is provided at the light source mounting portion 11. For example, the laser light source assembly 30 is mounted on the inner surface 112 of the light source mounting portion 11. The laser light source assembly 30 is configured to emit the laser.

The laser light source assembly 30 includes a laser chip 32 and a reflector 34. In an embodiment, the laser chip 32 is configured to emit laser and electrically connected to the lead wire 50 (FIG. 2). For example, the laser chip 32 may be electrically connected to the lead wire 50 and further connected to a power supply through the lead wire 50, so that the power supply can supply power to the laser chip 32. In this embodiment, the laser chip 32 includes two light emission sources 321, and each of the emission sources 321 is configured to emit laser. The two emission sources 321 can increase the light emittance area and luminous intensity of the laser. In some other embodiments, the laser chip 32 may also include a single light emission source 321 or three or more emission sources 321. The reflector 34 is provided on the optical path of the laser to reflect the incident laser onto the light window 60. In this embodiment, the reflector 34 includes a reflective surface 341. The reflective surface 341 is opposite to a light outlet of the laser chip 32, and is at an angle of 45° with the inner surface 112 of the light source mounting portion 11, so that the laser emitted by the laser chip 32 can be emitted towards the top of the laser packaging device 1 after being reflected by the reflective surface 341, thereby achieving light emission from the top. For example, the laser is emitted vertically from the top of the laser packaging device 1. In some other embodiments, the direction of the laser emitted from the laser packaging device 1 can be controlled by changing the angle between the reflective surface 341 and the inner surface 112 of the light source mounting portion 11.

In this embodiment, the reflector 34 is a reflecting prism, and the longitudinal section of the reflecting prism is substantially trapezoidal. In an embodiment, the longitudinal section refers to the plane obtained by intercepting the reflecting prism along a direction perpendicular to the length direction of the base 10. In some other embodiments, the reflector 34 may also be a triangular prism or a rectangular plate. For example, the reflector 34 may be a flat reflector. It is appreciated that, the reflector 34 may also have other shapes, as long as it has the function of reflecting the incident laser to the light window 60.

In this embodiment, the laser light source assembly 30 further includes a heat sink 36 provided on the inner surface 112 of the light source mounting portion 11, and the laser chip 32 is provided on the side of the heat sink away from the inner surface 112. The heat sink 36 is configured to dissipate the heat of the laser chip 32. For example, the heat generated by the laser chip 32 can be transferred to the base 10 through the heat sink 36, and further exchanged with the external environment through the base 10 to implement heat dissipation of the laser chip 32. In this embodiment, the number of the heat sinks 36 is equal to the number of the laser chips 32. That is, one laser chip 32 is provided at the light source mounting portion 11 through one corresponding heat sink 36. In some other embodiments, the number of heat sinks 36 is not equal to the number of the laser chips 32. For example, a plurality of laser chips 32 can share one heat sink 36 for heat dissipation.

In this embodiment, there are a plurality of laser light source assemblies 30, and the plurality of laser light source assemblies 30 are provided at intervals. The plurality of laser light source assemblies 30 can increase the luminous intensity of the laser packaging device 1 to meet the demands for luminous intensity. In this embodiment, the number of laser light source assemblies 30 is four. In some other embodiments, the number of laser light source assemblies 30 may also be two, three, five, or more.

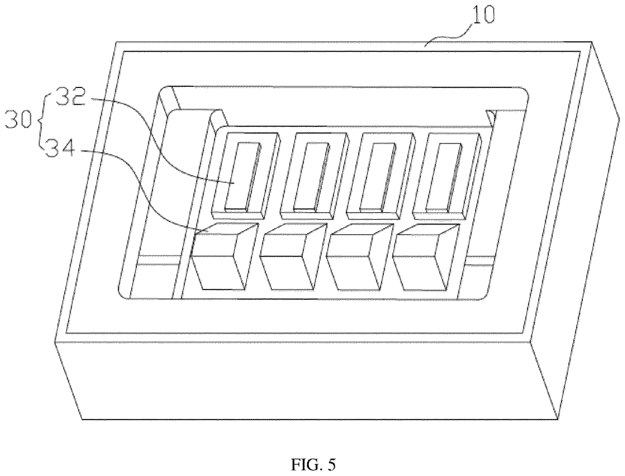

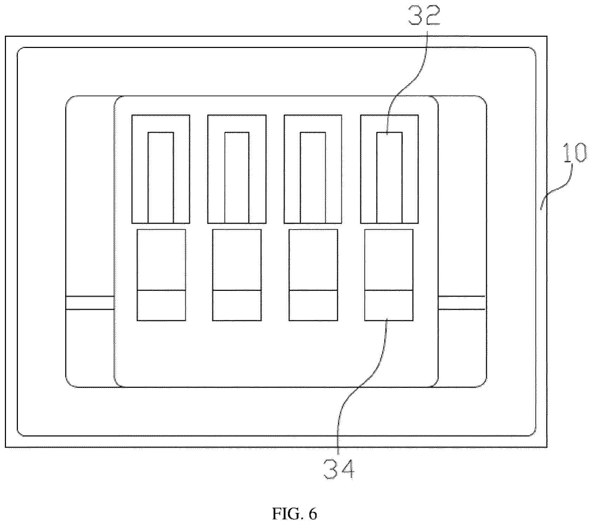

As shown in FIG. 5 and FIG. 6, the plurality of laser light source assemblies 30 are provided at intervals along the length direction of the base 10, and the laser chip 32 and the reflector 34 of each laser light source assembly 30 are provided along the width direction of the base 10. In this embodiment, the plurality of laser light source assemblies 30 are arranged in a single row along the length direction of the base 10. In some other embodiments, the plurality of laser light source assemblies 30 can also be arranged in double or multiple rows, which can be set according to actual needs and are not limited herein.

In this embodiment, the plurality of laser chips 32 form a row along the length direction of the base 10, and the plurality of reflectors 34 form another row. That is, the arrangement directions of the laser chip 32 and the reflector 34 of each laser light source assembly 30 are the same, such that the manufacturing operation of the laser light source assemblies 30 is convenient and the manufacturing efficiency is high. For example, after completing the mounting of any reflector 34 or laser chip 32 through a certain process, the mounting of other reflectors 34 or laser chips 32 can be completed by repeating the process.

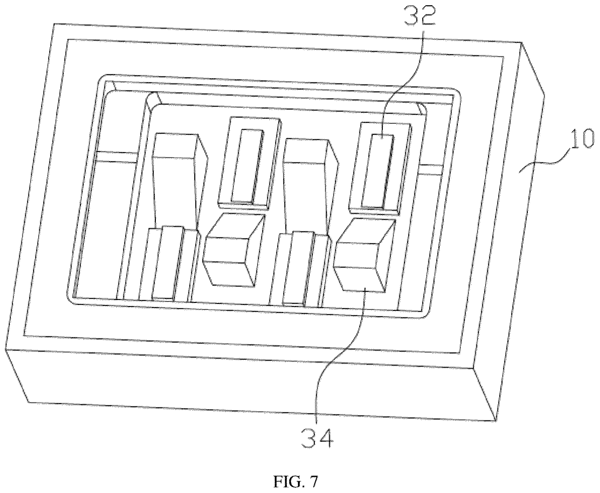

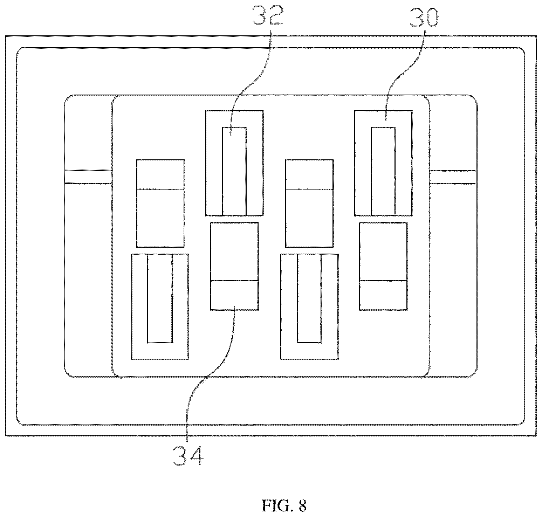

In an embodiment, as shown in FIG. 7 and FIG. 8, the laser light source assemblies 30 are provided at intervals along the length direction of the base 10, one laser chip 32 is provided between every two adjacent reflectors 34 along the length direction of the base 10, and one reflector 34 is provided between every two adjacent laser chips 32. The reflector 34 and the laser chip 32 of the laser light source assemblies 30 in one direction and the reflectors 34 and the laser chips 32 of the laser light source assemblies 30 in the opposite direction are sequentially provided one after another along the length direction of the base 10. That is, the reflector 34 and the laser chip 32 of a laser light source assembly 30 is provided in a direction opposite to that of the reflector 34 and the laser chip 32 of an adjacent laser light source assembly 30 along the width direction of the base 10. The arrangement directions of the laser chips 32 and the reflectors 34 of the two adjacent laser light source assemblies 30 are contrary to each other along the width direction of the base 10. For example, the first laser light source assembly 30 is arranged in a forward direction, the second laser light source assembly 30 is arranged in a reverse direction, and the third laser light source assembly 30 is placed upright, and so on. From the perspective shown in FIG. 8, for example, the arrangement in the forward direction is defined as the reflector 34 is located at the upper end of the laser chip 32, while the arrangement in a reverse direction is defined as the reflector 34 is located at the lower end of the laser chip 32, and the laser light source assemblies in the direction sequentially from left to right is defined as the first, second and third laser light source assemblies 30, and so on.

Compared with that the laser chip 32 and the reflector 34 of each laser light source assembly 30 are arranged in a same direction, the laser chips 32 and the reflectors 34 of two adjacent laser light source assemblies 30 are arranged in opposite directions, such that a spacing between two adjacent laser chips 32 is increased, the plurality of laser chips 32 are distributed more dispersed, and thus the heat generated by the plurality of laser chips 32 is distributed over a larger area. That is, the heat transfer channel is expanded. As a result, the heat dissipated by the laser chips 32 is more prone to be transferred to the external environment through the base 10, the temperatures of the laser chips 32 are reduced, and the service lives of the laser chips 32 are extended.

In this embodiment, a laser chip 32 of each of the laser light source assemblies 30 is staggered from a reflector 34 of an adjacent laser light source assembly 30 along the width direction of the base 10 to increase the spacing, in the width direction of the base 10, between the adjacent laser chips 32. As a result, the heat transfer channel is further expanded, the heat generated by the laser chips 32 is more prone to be transferred to the external environment through the base 10, the temperatures of the laser chips 32 are reduced, and the service lives of the laser chips 32 are extended. It should be noted that when the laser chip 32 of each of the laser light source assemblies 30 is staggered from and the reflector 34 of the adjacent laser light source assembly 30, and it is necessary to ensure that the light emission position and light emission path of the laser from the light window do not change spatially.

As shown in FIG. 2 and FIG. 3, the lead wire 50 passes through the support portion 13. For example, the lead wire 50 can be provided inside a body of the base 10. While sintering the embryoid body (precursor) of the base 10, the lead wire 50 can be fixed inside the support portion 13. The body of the base 10 refers to the structure of the base 10 before sintering. The material of the lead wire 50 may be copper or other metals with high melting points.

The lead wire 50 includes a first end 52 and a second end 54 opposite to each other. The first end 52 is provided in the accommodating cavity 15 and configured to be electrically connected to the laser chip 32. For example, the first end 52 of the lead wire 50 is provided on the step surface 138, and the second end 54 is provided on the bottom surface 134. The lead wire 50 is led out from the accommodating cavity 15 to the bottom surface 134 of the support portion 13, such that the side surface 136 of the support portion 13 can be flush with the outer surface 114 of the light window 60 to reduce the size of the base 10 and cause the laser packaging device 1 to be an SMD (Surface Mounted Devices) encapsulation structure.

A circuit layer 521 is provided at the first end 52, and the circuit layer 521 can be provided on the step surface 138. A circuit pad 541 is provided at the second end 54, and the circuit pad 541 can be provided on the bottom surface 134 and connected to a power line, with the function of being electrically connected to the power supply. That is, the laser chip 32 can be electrically connected to the power supply through the circuit pad 541, such that the power supply can supply the laser chip 32.

In this embodiment, there are two lead wires 50. That is, the numbers of the circuit layers 521 and the circuit pads 541 are both two. The two circuit layers 521 are provided on two step surfaces 138, respectively, and are electrically connected to the positive and negative electrodes of each laser chip 32, respectively. The two circuit pads 541 are electrically connected to the positive and negative electrodes of the power supply, respectively.

The light window 60 covers the top surface 132 of the support portion 13 to seal the accommodating cavity 15 and seal the laser light source assembly 30 in the accommodating cavity 15. The laser reflected by the reflector 34 is emitted from the light window 60.

The light window 60 is provided on the top surface 132 of the support portion 13 to seal the accommodating cavity 15, so as to protect the laser light source assembly 30 inside the accommodating cavity 15 without affecting the emission of the laser beam. In this embodiment, the light window 60 is substantially a rectangular plate, which is adapted to the support portion 13 of the rectangular frame. In some other embodiments, when the support portion 13 is cylindrical, the light window 60 may also have a circular structure. The material of the light window 60 may be optical glass, or other transparent materials such as sapphire. The light window 60 may be a fully transparent structure. In some other embodiments, the light window 60 can also be a partially transparent structure. That is, the light window 60 is substantially a rectangular annular structure or a circular annular structure. For example, the area corresponding to the laser chip 32 is configured as a transparent area, while the other areas are configured as non-transparent areas, such that the light window 60 has a function similar to an aperture slot, and thus the light window 60 also has the function of shaping the spot while emitting the laser.

As shown in FIG. 2 and FIG. 3, the laser packaging device 1 may also include a collimating lens 80. The collimating lens 80 is provided at the side of the light window 60 away from the base 10. The collimating lens 80 can collimate the laser emitted by the laser light source assembly 30, so as to improve the imaging quality of the laser. The collimating lens 80 can be bonded to the light window 60, for example, through UV (Ultraviolet Rays) curing adhesive, or other thermosetting adhesives with good adhesion performance and low stress to glass materials.

The collimating lens 80 includes a lens body 81 and a plurality of collimating units 83. The lens body 81 is connected to the light window 60. For example, the lens body 81 may be bonded to the light window 60 through UV curing adhesive. The plurality of collimating units 83 are all provided protruding from the lens body 81. The collimating units 83 can be integrally provided with the lens body 81. Each of the collimating units 83 corresponds to a laser light source assembly 30, such that the laser emitted by each laser chip 32 can be collimated by the corresponding collimating unit 83. In this embodiment, the number of the collimating units 83 is equal to the number of the laser light source assemblies 30. For example, there are four collimating units 83, which are sequentially arranged along the length direction of the base 10. When the laser light source assemblies 30 are arranged in multiple rows, the plurality of collimating units 83 may also be arranged in multiple rows, as long as they can satisfy the purpose that each collimating unit 83 corresponds to one laser light source assembly 30.

The laser packaging device 1 further includes a plurality of gold wires 90, and each of the plurality of gold wires 90 is connected to the laser chip 32 and the circuit layer 521. For example, the two opposite ends of each of the gold wires 90 are welded to the laser chip 32 and the circuit layer 521, respectively. In this embodiment, each laser chip 32 is connected to two gold wires 90. When the number of laser chips 32 is four, the number of gold wires 90 is eight. Four of the gold wires 90 are connected to the positive electrodes of the four laser chips 32 and one of the circuit layers 521, respectively, and the other four gold wires 90 are connected to the negative electrodes of the four laser chips 32 and the other circuit layers 521, respectively.

To sum up, in the laser packaging device 1 according to the present disclosure, the light source mounting portion 11 and the support portion 13 are integrally provided, so as to simplify the manufacturing process of the base 10, thereby simplifying the manufacturing process of the laser packaging device 1. In addition, the first end 52 of the lead wire 50 is provided in the accommodating cavity 15, and the second end 54 is provided on the bottom surface 134 of the support portion 13, such that the side surface 136 of the support portion 13 can be flush with the outer surface 114 of the light window 60, which is favorable to reducing the size of the base 10 and implementing miniaturization of the laser packaging device 1. The laser chip 32 of each of the laser light source assemblies 30 is staggered from the reflector 34 of the adjacent laser light source assembly 30 along the width direction of the base 10 to increase the spacing, in the width direction of the base, between two adjacent laser chips 32. As a result, the heat transfer channel is expanded, the heat emitted by the laser chip 32 is more prone to be transferred to the external environment through the base 10, the temperatures of the laser chips 32 are reduced, and the service lives of the laser chips 32 are extended.

The above embodiments only express several implementation examples of the present disclosure, the description thereof is specific and detailed, but should not be understood as limitations to the scope of the present disclosure. It should be pointed out that for those skilled in the art, deformations and improvements can be made without departing from the concept of the present disclosure, all of which fall within the protection scope of the present disclosure. Therefore, the protection scope of the present disclosure should be subject to the attached claims.

## Claims

1. A laser packaging device (1), comprising:
a base (10) comprising a light source mounting portion (11) and a support portion (13), wherein the light source mounting portion (11) and the support portion (13) are integrally provided and cooperate to form an accommodating cavity (15), and the support portion (13) comprises a top surface (132) and a bottom surface (134);
a laser light source assembly (30) accommodated in the accommodating cavity, wherein the laser light source assembly (30) is provided at the light source mounting portion (11) and is configured to emit laser;
a lead wire (50) passing through the support portion (13), wherein the support portion (13) comprises a first end (52) and a second end (54) opposite to each other, the first end (52) of the lead wire is provided in the accommodating cavity (15) and is electrically connected to the laser light source assembly (30), and the second end (54) of the lead wire (50) is provided on the bottom surface (134); and
a light window (60) configured to cover the top surface(132) of the support portion to seal the accommodating cavity (15), wherein the laser is emitted through the light window (60).

2. The laser packaging device (1) according to claim 1, wherein the support portion (13) further comprises a side surface (136) connected to the top surface (132) and the bottom surface (134), and the side surface is flush with a part of an outer surface (114) of the light window (60).

3. The laser packaging device (1) according to claim 1, wherein the light source mounting portion (11) comprises an inner surface (112) provided between the top surface (132) and the bottom surface (134) of the support portion (13), the laser light source assembly (30) is provided on the inner surface (112), and wherein the support portion (13) further comprises a step surface (138) provided below the top surface(132) and above the inner surface (112), and a first end of the lead wire (50) is provided on the step surface (138).

4. The laser packaging device (1) according to claim 1, wherein the laser light source assembly (30) comprises a laser chip (32) and a reflector (34), the laser chip (32) is electrically connected to a first end of the lead wire (50) and comprises two light emission sources(321), each of the light emission sources (321) is configured to emit the laser, and the laser is reflected to the light window through the reflector (34).

5. The laser packaging device (1) according to claim 4, comprising a plurality of laser light source assemblies (30), wherein the plurality of laser light source assemblies are provided at intervals.

6. The laser packaging device (1) according to claim 5, wherein the base (10) comprises a length direction and a width direction, the plurality of laser light source assemblies (30) are provided at intervals along the length direction of the base (10), a laser chip (32) and a reflector (34) of each of the laser light source assemblies (30) are provided along the width direction of the base (10), and one laser chip (32) is provided between every two adjacent reflectors (34) along the length direction of the base (10).

7. The laser packaging device (1) according to claim 6, wherein a laser chip (32) of each of the laser light source assemblies (30) is staggered from a reflector (34) of an adjacent laser light source assembly (30) along the width direction of the base (10), to increase a spacing between two adjacent laser chips (32) in the width direction of the base (10).

8. The laser packaging device (1) according to claim 1, wherein the base is made of ceramic material.

9. The laser packaging device (1) according to any one of claims 1 to 8, wherein the laser packaging device (1) further comprises a collimating lens (80), and the collimating lens (80) is provided on a side of the light window (60) away from the base.

10. The laser packaging device (1) according to claim 9, wherein the collimating lens (80) comprises a lens body (81) and a plurality of collimating units (83), the lens body (81) is connected to the light window (60), the plurality of collimating units (83) are provided on the lens body (81), the laser packaging device (1) comprises a plurality of laser light source assemblies (30), and each of the plurality of laser light source assemblies (30) corresponds to one of the plurality of collimating units (83).
